**Europäisches Patentamt**

**European Patent Office**

**Office européen des brevets**

(11) Veröffentlichungsnummer: **0 140 125**
**A2**

## (12) EUROPÄISCHE PATENTANMELDUNG

(21) Anmeldenummer: **84111124.8**

(22) Anmeldetag: **18.09.84**

(51) Int. Cl.⁴: **C 23 C 14/06**

(30) Priorität: **30.09.83 DE 3335623**

(43) Veröffentlichungstag der Anmeldung:
**08.05.85 Patentblatt 85/19**

(84) Benannte Vertragsstaaten:
**AT BE CH DE FR GB IT LI LU NL SE**

(71) Anmelder: **Siemens Aktiengesellschaft**
**Berlin und München Wittelsbacherplatz 2**
**D-8000 München 2(DE)**

(72) Erfinder: **Argyo, Wilhelm**
**Nüchternbrunnweg 7**
**D-8151 Osterwarngau(DE)**

(54) **Verfahren zur Herstellung einer Kohlenstoff enthaltenden Schicht, Kohlenstoff enthaltende Schicht, Verwendung einer Kohlenstoff enthaltenden Schicht und Vorrichtung zur Durchführung eines Verfahrens zur Herstellung einer Kohlenstoff enthaltenden Schicht.**

(57) Verfahren zur Herstellung einer Kohlenstoff enthaltenden Schicht, Kohlenstoff enthaltende Schicht, Verwendung einer Kohlenstoff enthaltenden Schicht und Vorrichtung zur Durchführung eines Verfahrens zur Herstellung einer Kohlenstoff enthaltenden Schicht.

Eine Kohlenstoff enthaltende Schicht (C) soll auf einem Substrat (S) durch Aufsputtern hergestellt werden können, wobei die Kohlenstoff enthaltende Schicht (C) auf beinahe jedem Substrat (S) gut haftend und als sehr dünne Schicht aufgetragen werden kann und wobei die Kohlenstoff enthaltende Schicht (C) auch eine geringe Leitfähigkeit aufweist. Beim Aufsputtern werden in die Kohlenstoff enthaltende Schicht (C) Kohlenwasserstoff -Molekülteile oder Kohlenwasserstoff-Moleküle mit eingebaut. Eine so beschaffene Kohlenstoff enthaltende Schicht (C) haftet auf beinahe jedem Substrat, ist beinahe kratzfest und hilft Aufladungen und Kontaminationen bei Beschuß mit geladenen Teilchen zu vermeiden.

FIG 2

EP 0 140 125 A2

SIEMENS AKTIENGESELLSCHAFT ~1·          Unser Zeichen
Berlin und München                      VPA

                                        83 P 1 8 2 5 E

Verfahren zur Herstellung einer Kohlenstoff enthaltenden Schicht, Kohlenstoff enthaltende Schicht, Verwendung einer Kohlenstoff enthaltenden Schicht und Vorrichtung zur Durchführung eines Verfahrens zur Herstellung
einer Kohlenstoff enthaltenden Schicht.

Die Erfindung betrifft ein Verfahren zur Herstellung einer
Kohlenstoff enthaltenden Schicht auf einem Substrat durch
Aufsputtern nach dem Oberbegriff des Anspruchs 1, eine
Kohlenstoff enthaltende Schicht nach dem Oberbegriff des
Anspruchs 10, eine Verwendung einer Kohlenstoff enthaltenden Schicht und eine Vorrichtung zur Durchführung eines Verfahrens zur Herstellung einer Kohlenstoff enthaltenden
Schicht.

Bei der elektronenmikroskopischen Abbildung von Proben, die
aus isolierenden Materialien bestehen, treten durch den
Elektronenbeschuß Aufladungen und Kontaminationen auf den
abzubildenden Oberflächen der Proben auf, welche die Bildqualität beeinträchtigen.

Bisher mußte zur Vermeidung von Aufladungen des isolierenden Materials von abzubildenden Oberflächen die Energie des
Elektronenstrahls so eingestellt werden, daß die Zahl der
auf die Probe treffenden Elektronen gleich der Zahl der
emittierten Elektronen, nämlich der Sekundärelektronen zusammen mit den rückgestreuten Elektronen, ist. War es bisher aus irgendwelchen Gründen nicht möglich, die Energie
des Primärelektronenstrahls so einzustellen, daß die Zahl
der auf die Probe treffenden Elektronen gleich der Zahl der

My 1 Bla / 29.9.1983

von der Oberfläche der Probe emittierten Elektronen ist, so wurde nach dem Stand der Technik auf die abzubildende Oberfläche eine metallische Schicht aufgebracht, welche die überschüssige Ladung abfließen läßt und dadurch bei der Bestrahlung der Oberfläche mit dem Primärelektronenstrahl eine Aufladung dieser Oberfläche vermeiden hilft. Wird diese metallische Schicht, die zur Vermeidung von Aufladungen auf eine abzubildende Oberfläche aufgebracht wird, sehr dünn gehalten, beispielsweise kleiner 1 nm, so läßt sich dadurch z.B. bei Oberflächenwellen-Bauelementen die Aufladung verringern, ohne daß die Funktion dieser Oberflächenwellen-Bauelemente gestört wird. Das Verfahren, eine metallische Schicht zur Verhütung von Aufladungen auf eine abzubildende Oberfläche aufzubringen, kann bei Oberflächenwellen-Bauelementen bis zu Frequenzen von ca. 300 MHz angewandt werden. Bei höheren Frequenzen treten Hochfrequenz-Kurzschlüsse auf, die sowohl bei abzubildenden Oberflächen von Oberflächenwellen-Bauelementen als auch von integrierten Schaltkreisen, bei denen die Schaltzeit einige Nanosekunden beträgt, zu beobachten sind.

Neben den Aufladungen von abzubildenden Oberflächen beeinträchtigen auch Kontaminationen auf abzubildenden Oberflächen die Bildqualität. Kontaminationen können zwar durch ein ölfreies Vakuum und durch eine spezielle Reinigung der abzubildenden Proben vermieden werden. Bei der Elektronenstrahl-Meßtechnik sind diese Bedingungen eines ölfreien Vakuums und einer speziellen Reinigung dser abzubildenden Proben jedoch praktisch nicht erfüllbar.

Auch biologische, medizinische oder sonstige Proben, wie z.B. Papier oder Glas oder Keramik oder sonstige Oberflächen, die aus isolierenden Materialien oder aus solchen Materialien bestehen, auf denen eine störende Kontamination auftreten kann, sollen elektronenmikroskopisch abgebildet werden können. Da auf manchen abzubildenden Oberflächen, wie z.B. auf Keramik, metallische Schichten sehr schlecht halten, wird darüber hinaus ein Mittel benötigt, das einerseits Aufladungen und Kontaminationen auf abzubildenden Oberflächen verhindern hilft und andererseits auf beinahe jedem möglichen Substrat gut haftet.

Der vorliegenden Erfindung liegt die Aufgabe zugrunde, ein Verfahren zur Herstellung einer Kohlenstoff enthaltenden Schicht und eine Kohlenstoff enthaltende Schicht der eingangs genannten Art anzugeben, wobei die Schicht auf beinahe jedem Substrat gut haftet und als sehr dünne Schicht aufgetragen werden kann und die auch eine geringe Leitfähigkeit aufweist.

Diese Aufgabe wird erfindungsgemäß durch ein Verfahren nach dem Anspruch 1 und durch eine Kohlenstoff enthaltende Schicht nach dem Anspruch 10 gelöst. Ausgestaltungen und Vorteile der Erfindung sind in den Unteransprüchen, der Beschreibung und der Zeichnung dargestellt.

Mit einem erfindungsgemäßen Verfahren wird eine erfindungsgemäße Schicht auf ein Substrat aufgesputtert, wobei diese Schicht in irgendeiner Form Kohlenwasserstoffe enthält. Bei einem erfindungsgemäßen Verfahren werden diese Kohlenwasserstoffe so in die Kohlenstoff enthaltende Schicht eingebaut, daß die dabei entstehende erfindungsgemäße Schicht viele physikalische Eigenschaften besitzt, wie sie ein Kunststoff aufweist. Beispielsweise haftet eine erfindungsgemäße Schicht auf Substraten wie Papier, Keramik oder anderen Substanzen, auf denen beispielsweise metallische Schichten nur sehr schlecht haften würden. Wenn beispielsweise eine erfindungsgemäße Schicht auf Papier aufgebracht wird, bildet sie auf diesem Papier eine harte Schicht, die beispielsweise durch Reiben mit einem Finger nicht abkratzbar ist.
Soll beispielsweise eine weitere Schicht, insbesondere
eine metallische Schicht, beispielsweise auf Keramik aufgebracht werden, wo beispielsweise eine aufgebrachte Goldschicht sehr leicht abgerieben werden kann, so kann eine
erfindungsgemäße Schicht dadurch als Haftuntergrund für
die weitere Schicht dienen, daß zunächst auf Keramik eine
erfindungsgemäße Schicht aufgebracht wird, die auf Keramik
gut haftet, und daß dann erst auf eine erfindungsgemäße
Schicht die eigentlich gewünschte Schicht aufgebracht
wird. Auf diese Weise dient eine erfindungsgemäße Schicht
als Haftvermittler für eine gut haftende gewünschte
Schicht auf einem Substrat, auf dem diese gewünschte
Schicht ohne Haftvermittler nur sehr schlecht haften würde.

Eine erfindungsgemäße Schicht kann sehr gleichmäßig und
als sehr dünne Schicht mit einer Dicke im unteren Nanometerbereich, beispielsweise für elektronenmikroskopische
Untersuchungen im Bereich zwischen 6 nm und 15 nm, insbesondere zwischen 10 und 15 nm, aufgetragen werden. Mit
einem erfindungsgemäßen Verfahren können dünnere Schichten
erzielt werden als mit einer Metall-Bedampfung. Wird beispielsweise eine Goldschicht auf ein Substrat aufgedampft,
so ergibt sich bei 3 nm Dicke der Goldschicht keine gleichmäßig dicke Goldschicht, vielmehr ergibt sich bei einer
solchen Dicke einer Goldschicht eine Inselbildung, wobei
sich an metallischen Inseln bei elektronenmikroskopischen
Abbildungen elektrische Ladungen ansammeln, die die Bildqualität verschlechtern und Kurzschlüsse verursachen.

Eine erfindungsgemäße Schicht wird durch Aufsputtern in
einer Atmosphäre erzeugt, die neben Edelgasatomen auch Kohlenwasserstoffmoleküle enthält. Diese Kohlenwasserstoffmoleküle können gezielt in eine Vorrichtung zur Durchführung eines erfindungsgemäßen Verfahrens eingebracht werden. Besonders günstig scheinen langkettige Kohlenwasserstoffmoleküle, wie beispielsweise Ölmoleküle zu sein. Beispielsweise kann ein Stück Papier, das mit einem Tropfen Öl versehen ist, in eine Vorrichtung zur Durchführung eines erfindungsgemäßen Verfahrens gebracht werden. Werden bei einer Vorrichtung zur Durchführung eines erfindungsgemäßen Verfahrens Vakuumpumpen mit Pumpölen verwendet, so genügt für die Durchführung eines erfindungsgemäßen Verfahrens zum Einbringen von Kohlenwasserstoffmolekülen in die Sputteratmosphäre ein schlechtes Vakuum zwischen insbesondere $10^{-1}$ mbar und $10^{-3}$ mbar. Pumpöle mit einem relativ hohen Dampfdruck sind besonders günstig bei der Durchführung eines erfindungsgemäßen Verfahrens.

Beim Sputtervorgang wird in einer verdünnten Edelgasatmosphäre eine Entladung gezündet. Die Edelgasionen werden dabei aus dem Edelgasplasma von einem Target extrahiert, das dabei zerstäubt wird. Bei einem erfindungsgemäßen Verfahren enthält das Target Kohlenstoffatome. Wenn Kohlenstoffatome nach ihrer Zerstäubung auf dem Substrat einen Überzug bilden, werden bei einem erfindungsgemäßen Verfahren gleichzeitig auch Kohlenwasserstoffmoleküle in diesen Überzug auf dem Substrat miteingebaut. Für eine erfindungsgemäße Schicht kommt es wesentlich darauf an, daß die Kohlenstoffatome und Kohlenwasserstoffmoleküle diffus auf das Substrat treffen und einen Überzug gleichmäßiger Dicke bewirken.

Wegen der enthaltenen Kohlenwasserstoffmoleküle weist eine erfindungsgemäße Schicht eine sehr geringe Leitfähigkeit zwischen insbesondere $10^{-13}$ und $10^{-14}$ Ohm auf. Eine solche Leitfähigkeit bewirkt bei elektronenmikroskopischen Abbildungen, daß die Ladungsträger einerseits schon abgeleitet werden, daß andererseits die Funktionen des abzubildenden Substrats aber noch nicht durch Kurzschlüsse gestört werden. Da nach Aufbringen einer erfindungsgemäßen
Schicht insbesondere die elektrischen Funktionen einer
integrierten Schaltung nicht gestört werden, eignet sich
eine erfindungsgemäße Schicht insbesondere zur elektronenmikroskopischen Abbildung sowohl von passivierten als auch
von nicht-passivierten elektronischen Bausteinen. Die Erfindung ermöglicht eine Bestrahlung von abzubildenden
Materialien mit Elektronenstrahlenergien, bei denen die
Zahl der auf die Probe auftreffenden Primärelektronen verschieden der Zahl der von der Probe emittierten Elektronen
ist. Die Erfindung ermöglicht eine zerstörungsfreie qualitative und auch quantitative Abbildung von Proben.

Eine erfindungsgemäße Schicht weist eine wesentlich geringere Leitfähigkeit auf als eine reine Kohleschicht, wie
sie nach dem Stand der Technik aufgesputtert werden konnte.
Eine Kohleschicht nach dem Stand der Technik verursacht
jedoch bei elektronenmikroskopischen Abbildungen ähnlich
wie eine dünne metallische Aufdampfschicht Kurzschlüsse.
Bei elektronenmikroskopischen Abbildungen werden durch die
Erfindung Aufladungen vermieden und Kontaminationen stark
verringert. Die Erfindung vereinfacht die quantitative
elektronenmikroskopische Potentialmessung an elektronischen
Bauteilen wesentlich und erhöht deren Genauigkeit. Die Erfindung ist jedoch nicht beschränkt auf elektronenmikroskopische Verfahren. Beispielsweise ist eine erfindungsgemäße Schicht auch geeignet zum mechanischen Schutz eines
Gegenstands oder als Haftvermittler beim Aufbringen irgendeiner Substanz auf irgendein Substrat, wenn diese Substanz
auf dem Substrat ohne Haftvermittler schlecht haften würde

0140125
83 P 1825 E

oder wenn ein Haftvermittler mit einer geringen Leitfähigkeit benötigt wird.

Die Erfindung ist anhand der Zeichnung näher erläutert.

Fig. 1 zeigt eine Vorrichtung, mit der nach dem Stand der Technik eine Kohleschicht auf ein Substrat aufgesputtert worden ist.

Fig. 2 zeigt eine erfindungsgemäße Vorrichtung, mit der ein erfindungsgemäßes Verfahren zur Erzeugung einer erfindungsgemäßen Schicht durchgeführt werden kann.

Fig. 3 zeigt die Verwendung einer erfindungsgemäßen Schicht bei einer elektronenmikroskopischen Abbildung.

Fig. 4 zeigt die Verwendung einer erfindungsgemäßen Schicht als Haftvermittler.

Fig. 5 zeigt die Verwendung einer erfindungsgemäßen Schicht als Überzug eines Substrats zum mechanischen Schutz.

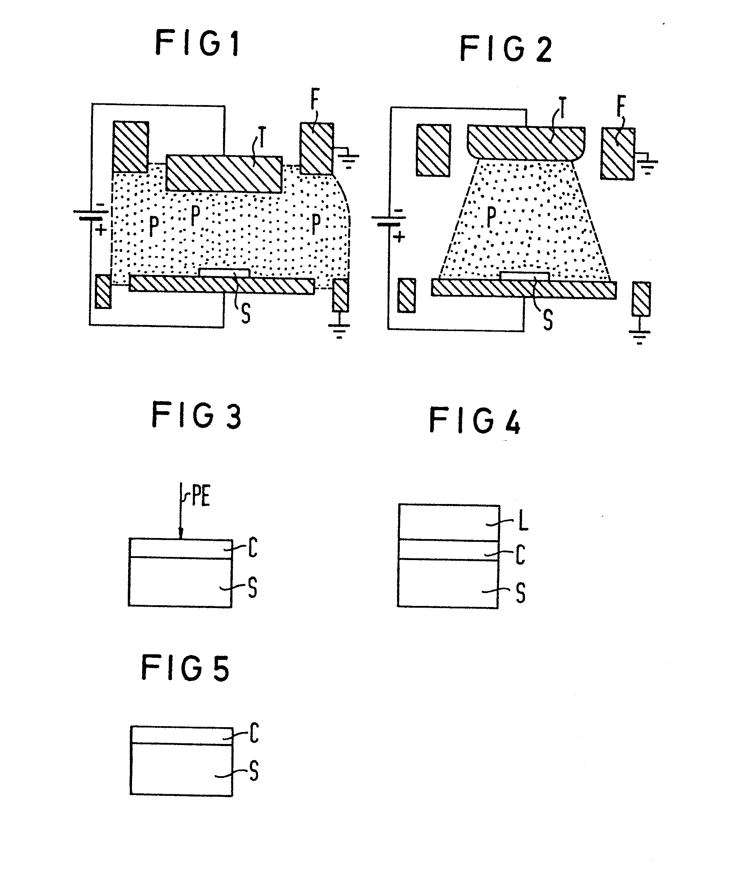

Figur 1 zeigt eine Vorrichtung, mit der nach dem Stand der Technik eine Kohleschicht auf ein Substrat S aufgesputtert wird. Bei diesem Sputterverfahren (Kathodenzerstäubung) handelt es sich um eine Gleichspannungsentladung (1,5 kV, 5-10 mA) bei einem Gasdruck von etwa $10^{-2}$·mbar zwischen parallelen Platten in ca. 2-5 cm Abstand. Das Target T (Kathode) wird von den Ionen aus dem Edelgasplasma P, das bei der Gasentladung entstanden ist, getroffen. Diese Ionen aus dem Plasma P schlagen aus dem Target T Kohlenstoffatome heraus, welche als Neutralatome zur Anode fliegen und auf dem auf der Anode liegenden Substrat S eine Kohlenstoffschicht erzeugen. Als Edelgasfüllung wird beispielsweise Argon benutzt. Die freie Weglänge der Kohlenstoffatome ist kleiner als der Abstand der Platten, wodurch die Kohlenstoffatome diffus auf das Substrat S auftreffen.

Fig.2 zeigt eine erfindungsgemäße Vorrichtung, mit der ein
erfindungsgemäßes Verfahren zur Erzeugung einer erfindungsgemäßen Schicht durchgeführt werden kann. Eine Sputteranlage nach dem Stand der Technik, beispielsweise eine
Sputteranlage der Fa. Technics (Hummer Jr.), muß folgendermaßen modifiziert werden, um eine erfindungsgemäße
Schicht erzeugen zu können:

1. Der Rand des Targets T wird abgerundet: Dies verhindert Überschläge zur Gerätemasse über den Fokussierungsring F.

2. Die Oberfläche des Targets T wird so glatt wie möglich
geschliffen: Dadurch wird eine wesentlich höhere
Absputterrate erreicht.

3. Die Anordnung des Targets T wird geändert: Das Plasma
P wird dadurch besser auf den Raum zwischen dem zu beschichtenden Substrat S und der Oberfläche des Targets T
fokussiert.

Ohne diese Maßnahmen 1. bis 3. ist ein erfindungsgemäßes
Aufsputtern einer erfindungsgemäßen Schicht mit einer
Sputteranlage nach dem beschriebenen Stand der Technik
nicht möglich. Den gravierendsten Effekt für ein erfindungsgemäßes Aufsputtern hat das Merkmal, daß die Oberfläche des Targets T so glatt wie möglich geschliffen wird.
Dadurch kann eine große Anzahl von Kohlenstoffatomen
gleichzeitig vom Target T abgesputtert werden. Den nächstwichtigen Effekt für ein erfindungsgemäße Verfahren hat
das Merkmal, daß das Plasma P so gut wie möglich auf den Raum zwischen dem Substrat S und der Oberfläche des Targets T fokussiert wird. Zu diesem Zweck wird ein Teil der Fokussierungseinrichtung F zwischen der Oberfläche des Targets T und dem Substrat S angeordnet. Unter den drei angegebenen Maßnahmen hat den geringsten Effekt die Abrundung der Oberfläche des Targets T. Diese Abrundung hat zur Folge, daß die Spannung für die Gasentladung zeitlich gleichmäßig wirksam bleibt.

Für ein erfindungsgemäßes Verfahren ist wichtig, daß beim Aufsputtern auch Kohlenwasserstoff-Moleküle, die sich zwischen der Oberfläche des Targets T und dem Substrat S befinden, auf irgendeine Weise zum Niederschlag auf dem Substrat S veranlaßt werden. Besonders effektiv geschieht dies dadurch, daß bei der Gasentladung auch langkettige Kohlenwasserstoff-Moleküle gecrackt werden, dabei quasi ebenso wie die Kohlenstoffatome zerstäubt werden, und daß Teile von langkettigen Kohlenwasserstoff-Molekülen gemeinsam mit zerstäubten Kohlenstoffatomen einen diffusen Niederschlag auf dem Substrat S bilden. Durch Anzahl und Art der Kohlenwasserstoff-Moleküle, die sich zwischen Target T und Substrat S befinden, kann die Leitfähigkeit und die Härte der erfindungsgemäßen Schicht auf dem Substrat S beeinflußt werden. Je mehr langkettige Kohlenwasserstoff-Moleküle sich zwischen Target T und Substrat S befinden, desto härter und desto hochohmiger wird die erzeugte erfindungsgemäße Schicht auf dem Substrat S.

Fig.3 zeigt die Verwendung einer erfindungsgemäßen Schicht für elektronenmikroskopische Abbildungen. Eine erfindungsgemäße Schicht C, die Kohlenwasserstoff-Moleküle enthält, ist mit einem erfindungsgemäßen Verfahren auf einem abzubildenden Substrat S aufgebracht worden. Trifft nun ein Primärelektronenstrahl PE auf diese erfindungsgemäße Schicht C auf, so kann in bekannter Weise die Oberfläche des Substrates S abgebildet werden. Bei der qualitativen Abbildung eines Substrates S kann dabei die Lehre der US-Patentschrift 4 223 220 und bei der quantitativen Abbildung des Substrates S kann die Lehre der US-Patentschrift 4 277 679 verwendet werden. Die erfindungsgemäße Schicht C ermöglicht dabei eine Beschleunigungsspannung von beispielsweise 2,5 kV für den Primärelektronenstrahl PE, ohne daß Aufladungen der abzubildenden Oberfläche auftreten und die Bildqualität verschlechtern würden. Eine für eine elektronenmikroskopische Abbildung geeignete erfindungsgemäße Schicht C wird beispielsweise mit einer erfindungsgemäßen Vorrichtung nach Fig.2 nach 5-10 min Sputterzeit erzielt.

Wenn das Substrat S ein elektronischer Baustein ist und mit einer Betriebsspannung angesteuert wird, treten bei Gleichspannungs- und bei Hochfrequenzsignalen bei dieser Betriebsspannung keine Kurzschlüsse auf. Als Substrat S kann daher auch eine integrierte Schaltung verwendet werden. Von Vorteil ist außerdem der stark verringerte Einfluß der Kontamination. Dies wirkt sich insgesamt positiv auf eine quantitative Messung von elektronischen Bauteilen aus. Überdies können die Proben dadurch längere Zeit dem Elektronenbeschuß ausgesetzt werden.

Fig.4 zeigt die Verwendung einer erfindungsgemäßen Schicht C als Haftvermittler zwischen einem Substrat S und einer weiteren Substanz L. Beispielsweise haftet eine metallische Substanz wie Gold ohne Haftvermittler schlecht auf Keramik. Eine erfindungsgemäße Schicht C bewirkt eine gute Haftung von Gold auf Keramik dann, wenn sie als Haftvermittler zwischen Keramik und Gold angeordnet ist.

0140125
83 P 1825 E

Fig.5 zeigt die Verwendung einer erfindungsgemäßen Schicht C zum mechanischen Schutz eines Substrats S. Dabei verhindert die erfindungsgemäße Schicht C mechanische Beschädigungen des Substrats S.

Eine erfindungsgemäße Schicht C kann nicht nur zum mechanischen Schutz eines Substrats S dienen, sondern auch zum Schutz vor Aufladungen oder vor Kurzschlüssen.

Eine erfindungsgemäße Schicht C läßt sich durch Plasma-Ätzen mit Sauerstoff von einer Probe C rückstandsfrei beseitigen, ohne daß die Probe zerstört wird. Dies ist mit einer Metallschicht auf einer Probe nur sehr schwer oder überhaupt nicht möglich. Dazu kommt der geringe Zeit- und Kostenaufwand gegenüber der Beschichtung einer Probe mit einem sehr dünnen Metallfilm.

0140125
83 P 1825 E

Patentansprüche:

1. Verfahren zur Herstellung einer Kohlenstoff enthaltenden Schicht (C) auf einem Substrat (S) durch Aufsputtern,
dadurch gekennzeichnet,
daß beim Aufsputtern in die Kohlenstoff enthaltende Schicht (C) Kohlenwasserstoff-Molekülteile oder Kohlenwasserstoff-Moleküle mit eingebaut werden.

2. Verfahren nach Anspruch 1, dadurch gekennzeichnet, daß eine große Anzahl von Kohlenstoffatomen gleichzeitig von einem Target (T) abgesputtert wird.

3. Verfahren nach Anspruch 1 oder 2, dadurch gekennzeichnet, daß die Oberfläche eines Targets (T) so glatt wie möglich geschliffen wird.

4. Verfahren nach einem der Ansprüche 1 bis 3, dadurch gekennzeichnet, daß ein Plasma (P) so gut wie möglich in Richtung auf das Substrat (S) hin fokussiert wird.

5. Verfahren nach einem der Ansprüche 1 bis 4, dadurch gekennzeichnet, daß zwischen der Oberfläche des Targets (T) und dem Substrat (S) zumindest ein Teil einer Fokussierungseinrichtung (F) zur Fokussierung des Plasmas (P) angeordnet wird.

6. Verfahren nach einem der Ansprüche 1 bis 5, dadurch gekennzeichnet, daß die Spannung für die Gasentladung zeitlich gleichmäßig wirksam bleibt.

7. Verfahren nach einem der Ansprüche 1 bis 6, dadurch g e k e n n z e i c h n e t , daß die Kanten des Targets (T) abgerundet werden zur Vermeidung von Spannungsüberschlägen zwischen Target (T) und anderen Einrichtungen.

8. Verfahren nach einem der Ansprüche 1 bis 7, dadurch g e k e n n z e i c h n e t , daß gezielt eine Edelgas-Kohlenwasserstoff-Atmosphäre zwischen Target (T) und Substrat (S) erzeugt wird.

9. Verfahren nach einem der Ansprüche 1 bis 8, dadurch g e k e n n z e i c h n e t , daß ein Vakuum zwischen $10^{-1}$ und $10^{-3}$ mbar verwendet wird.

10. Kohlenstoff enthaltende Schicht (C), die durch Aufsputtern auf ein Substrat (S) aufgebracht worden ist, g e k e n n z e i c h n e t durch Kohlenwasserstoff-Molekülteile oder Kohlenwasserstoff-Moleküle, die in ihr eingebaut sind.

11. Kohlenstoff enthaltende Schicht (C) nach Anspruch 10, g e k e n n z e i c h n e t durch eine Leitfähigkeit zwischen $10^{-12}$ und $10^{-15}$ Ohm.

12. Kohlenstoff enthaltende Schicht (C) nach Anspruch 10 oder 11, g e k e n n z e i c h n e t durch eine Schichtdicke zwischen 6 und 15 nm.

13. Kohlenstoff enthaltende Schicht (C) nach einem der Ansprüche 10 bis 12, g e k e n n z e i c h n e t durch Abriebfestigkeit auf beinahe jedem Substrat (S).

14. Verwendung einer Kohlenstoff enthaltenden Schicht (C) nach einem der Ansprüche 1 bis 13, g e k e n n z e i c h n e t durch Papier als Substrat (S).

15. Verwendung einer Kohlenstoff enthaltenden Schicht (C) nach einem der Ansprüche 1 bis 13, g e k e n n z e i c h n - e t durch einen Isolator als Substrat (S).

16. Verwendung einer Kohlenstoff enthaltenden Schicht (C) nach einem der Ansprüche 1 bis 13, g e k e n n z e i c h - n e t durch Keramik als Substrat (S).

17. Verwendung einer Kohlenstoff enthaltenden Schicht (C) nach einem der Ansprüche 1 bis 16 zum Schutz eines Materials.

18. Verwendung einer Kohlenstoff enthaltenden Schicht (C) nach einem der Ansprüche 1 bis 17 als Haftvermittler für eine weitere Auflage (L).

19. Verwendung einer Kohlenstoff enthaltenden Schicht (C) nach Anspruch 18 als Haftvermittler für eine metallische Auflage (L).

20. Verwendung einer Kohlenstoff enthaltenden Schicht (C) nach einem der Ansprüche 1 bis 19 bei der elektronenmikroskopischen Abbildung von Oberflächen (S).

21. Verwendung einer Kohlenstoff enthaltenden Schicht (C) nach Anspruch 20 bei der elektronenmikroskopischen Abbildung einer passivierten Oberfläche eines elektronischen Bausteines (S).

22. Verwendung einer Kohlenstoff enthaltenden Schicht (C) nach Anspruch 20 oder 21 bei der elektronenmikroskopischen Abbildung einer nicht-passivierten Oberfläche eines elektronischen Bausteines (S).

23. Verwendung einer Kohlenstoff enthaltenden Schicht (C) nach Anspruch 20 bei der elektronenmikroskopischen Abbildung von Oberflächen von Oberflächenwellenfiltern (S).

24. Verwendung einer Kohlenstoff enthaltenden Schicht (C) nach Anspruch 20 bei der elektronenmikroskopischen Abbildung einer Oberfläche eines Isolators (S).

25. Vorrichtung zur Durchführung eines Verfahrens nach einem der Ansprüche 1 bis 9, dadurch  g e k e n n - z e i c h n e t , daß die Oberfläche des Targets (T) so glatt wie möglich geschliffen ist.

26. Vorrichtung zur Durchführung eines Verfahrens nach einem der Ansprüche 1 bis 9, 25, dadurch  g e k e n n - z e i c h n e t , daß das Plasma (P) in Richtung auf das Substrat (S) hin fokussiert ist.

27. Vorrichtung zur Durchführung eines Verfahrens nach einem der Ansprüche 1 bis 9, 25, 26, dadurch  g e k e n n - z e i c h n e t , daß der Rand des Targets (T) abgerundet ist.

# FIG 1

# FIG 2

# FIG 3

# FIG 4

# FIG 5